# FASCICULE DE BREVET EUROPEEN

(11) **EP 0 599 700 B1**
(45) Date de publication et mention de la délivrance du brevet: **07.02.1996**
(21) Numéro de dépôt: 93402797.0
(22) Date de dépôt: 17.11.1993
(51) Int. Cl.: H02M 1/12, H02M 5/00, H05K 9/00

(54) **Module de filtrage pour convertisseur de fréquence**
Filtermodul für Frequenzumrichter
Filter module for frequency converter

(30) Priorité: 27.11.1992 FR 9214529
(43) Date de publication de la demande: 01.06.1994
(73) Titulaire: SCHNEIDER ELECTRIC SA, F-92100 Boulogne-Billancourt (FR)
(72) Inventeur: Dore, Christophe, F-78330 Fontenay le Fleury (FR)
(74) Mandataire: Carias, Alain

(56) Documents cités:
- EP-A- 0 267 129
- WO-A-93/13587

## Description

La présente invention se rapporte à un module de filtrage pour convertisseur de fréquence constitué par un circuit de filtrage logé dans un boîtier et susceptible d'être. connecté audit convertisseur.

Les convertisseurs de fréquence destinés à l'alimentation des moteurs asynchrones triphasés comprennent essentiellement d'une part un redresseur qui fournit une tension continue à un filtre capacitif de lissage (convertisseur alternatif-continu) et d'autre part un onduleur à transistors de puissance ou à thyristors (convertisseur continu-alternatif) alimenté par ladite tension continue filtrée.

Le redresseur est un pont redresseur alimenté par un réseau monophasé ou triphasé.

L'onduleur est raccordé aux enroulements de phase du moteur. Il est composé d'un ou trois modules isolés suivant le calibre et il récrée, à partir de la tension continue fournie par le redresseur, un réseau triphasé à tension et fréquence variable.

La technique de commande des transistors est connue sous le nom de Modulation de Largeur d'Impulsions (en abrégé MLI - en anglais PWM pour Pulse Width Modulation), le but étant de générer une onde de courant aussi proche que possible d'une sinusoïde.

Dans de nombreux environnements, il est nécessaire de rajouter au convertisseur de fréquence, un ou plusieurs des cinq types de filtres suivants:
- filtre d'entrée pour limiter la propagation de perturbations à hautes fréquences sur le réseau;
- filtre d'entrée pour limiter le niveau d'harmoniques de basse fréquence de courant générés par le convertisseur;
- filtre d'entrée pour augmenter l'immunité du convertisseur à des surtensions réseau;
- filtre de sortie pour limiter la propagation dans le câble d'alimentation du moteur des perturbations électromagnétiques conduites de haute fréquence;
- filtre de sortie pour limiter les surtensions ou les variations brutales et de hautes fréquences aux bornes du moteur.

La présente invention a pour but de regrouper dans un même boîtier annexe les filtres d'entrée et de sortie appartenant à plusieurs ou à la totalité des types de filtres définis précédemment. Le module de filtrage permet un filtrage des entrées et des sorties du convertisseur et est facile à raccorder au convertisseur. L'encombrement de ce module est réduit. Il permet une bonne ventilation du convertisseur.

Conformément à l'invention, le module de filtrage contient un filtre d'entrée et un filtre de sortie montés de manière que les bornes d'entrée destinées au raccordement réseau et les bornes de sortie destinées au raccordement du moteur soient disposées du même côté du boîtier et que les raccordements avec le convertisseur de fréquence sont disposées sur un côté du boîtier destiné à être monté en vis à vis avec ledit convertisseur.

Selon une caractéristique, le filtre d'entrée et le filtre de sortie ont une terre commune.

Selon une caractéristique, le boîtier présente des embases de fixation permettant de ménager un canal de ventilation pour le convertisseur de fréquence.

L'invention va maintenant être décrite avec plus de détail en se référant à un mode de réalisation donné à titre d'exemple et représenté par les dessins annexés sur lesquels:

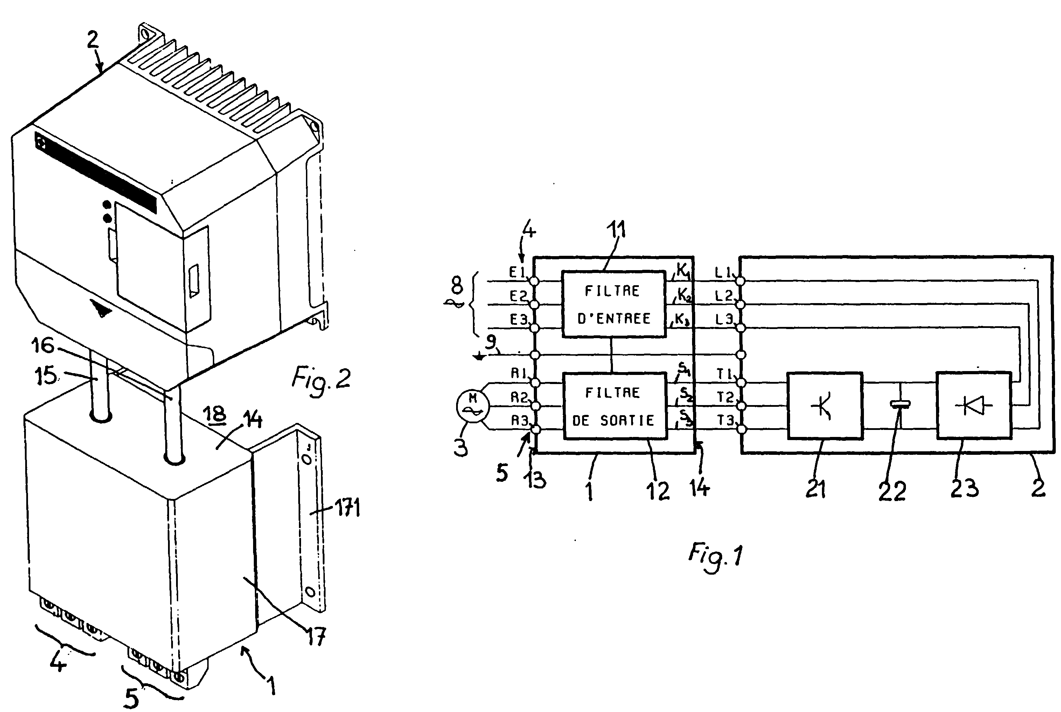

- la figure 1 est un schéma d'un convertisseur de fréquence équipé du module de filtrage selon l'invention ;
- la figure 2 est une vue en perspective du convertisseur de fréquence et du module de filtrage associé conforme à l'invention ;

Le module de filtrage objet de l'invention repéré 1 sur les dessins est associé à un convertisseur statique de fréquence repéré 2 servant de variateur de vitesse. Ce convertisseur de fréquence 2 comprend un onduleur 21 qui est relié par l'intermédiaire d'un filtre capacitif de lissage 22 à un redresseur à diodes 23 relié aux conducteurs de phase du réseau. L'onduleur 21 comporte trois bras de pont reliés chacun à un enroulement de phase d'un moteur asynchrone 3.

Chaque bras de l'onduleur est équipé, de manière connue en soi, de deux interrupteurs statiques associés à des diodes de récupération. Le point milieu de chaque couple d'interrupteurs d'un même bras est relié à un enroulement de phase du moteur 3.

Les interrupteurs statiques sont constitués par des transistors bipolaires ou MOS, soit par des composants MOS-bipolaires tels que ceux connus sous la designation IGBT, soit par des thyristors blocables du genre GTO soit par d'autres composants blocables analogues.

Un circuit de commande permet de rendre passants et bloquants les interrupteurs suivant une stratégie particulière.

Le module de filtrage 1 présente des bornes-d'entrée E₁, E₂, E₃ qui sont destinées à être raccordées aux phases du réseau 8. Ces bornes d'entrée repérées 4 dans leur ensemble sont reliées à un filtre d'entrée 11 logé dans le boîtier 17 du module 1. Les sorties K₁, K₂, K₃ de ce filtre d'entrée 11 constituent un faisceau 15 de conducteurs qui se branchent sur les bornes d'entrée L₁, L₂, L₃ du convertisseur de fréquence 2.

Les bornes de sortie T₁, T₂, T₃ du convertisseur de fréquence 2 servent au branchement des conducteurs S₁, S₂, S₃ d'un faisceau 16 qui aboutissent à un filtre de sortie 12 logé dans le boîtier 17 du module de filtrage 1. Les sorties de ce filtre de sortie 12 sont connectées à des bornes de sortie R₁, R₂, R₃ qui permettent le raccordement vers le moteur 3. Ces bornes de sortie sont repérées 5 dans leur ensemble.

Les bornes d'entrée 4 destinées au raccordement réseau et les bornes de sortie 5 destinées au raccordement du moteur soient disposées du même côté du boîtier repéré 13. Les faisceaux 15 et 16 de raccordement avec le convertisseur de fréquence 2 sont disposés sur le côté 14 du boîtier 17 qui est disposé vis à vis dudit convertisseur 2.

Le filtre d'entrée 11 et le filtre de sortie 12 ont une terre commune 9. Une borne est prévue sur la face 13 du boîtier et sert à la mise à la terre des filtres 11 et 12 et du convertisseur 2.

Le module de filtrage 1 est précablé, ce qui permet un raccordement rapide et sans source d'erreur avec le convertisseur 2.

Le module de filtrage 1 est fixé sur un support commun avec le convertisseur de fréquence 2 de manière à obtenir un ensemble pour lequel la mise en oeuvre (installation, raccordement, fixation) est réalisée de manière optimale.

Le boîtier 17 du module de filtrage présente des pattes 171 servant à la fixation sur rail ou sur platine. La face inférieure du boîtier qui est orientée vers les fixations est décalée du plan des pattes de fixation de manière à ménager un canal 18 servant à la ventilation du radiateur du convertisseur de fréquence.

Du fait de l'agencement adopté, le module de filtrage 1 peut être facilement connecté au convertisseur de fréquence 2.

Il est bien entendu que l'on peut, sans sortir du cadre de l'invention telle que définie par la revendication 1, imaginer des variantes et des perfectionnements de détail et de même envisager l'emploi de moyens équivalents.

## Revendications

1. Module de filtrage pour convertisseur de fréquence (2) constitué par un circuit de filtrage (12) logé dans un boîtier (17) et susceptible d'être connecté audit convertisseur (2), caractérisé par le fait qu'il contient un filtre d'entrée (11) et un filtre de sortie (12) montés de manière que les bornes d'entrée ( E₁, E₂, E₃) destinées au raccordement réseau et les bornes de sortie ( R₁, R₂, R₃) destinées au raccordement du moteur (3) soient disposées du même côté (13) du boîtier et que les raccordements (K₁, K₂, K₃, S₁, S₂, S₃) avec le convertisseur de fréquence (2) sont disposées sur un côté (14) du boîtier destiné à être monté en vis à vis avec ledit convertisseur.

2. Module selon la revendication 1, caractérisé par le fait que le filtre d'entrée (11) et le filtre de sortie (12) ont une terre commune.

3. Module selon l'une quelconque des revendications précédentes, caractérisé par le fait que le boîtier (17) présente des embases de fixation permettant de ménager un canal de ventilation (18) pour le convertisseur de fréquence (2).

4. Module selon l'une quelconque des revendications précédentes, caractérisé par le fait qu'il est précâblé.

## Patentansprüche

1. Filtermodul für Frequenzumrichter (2), bestehend aus einer Filterschaltung (12) in einem Gehäuse (17) zum Anschließen an einen Frequenzumrichter (2), dadurch gekennzeichnet, daß er einen Eingangsfilter 11 und einen Ausgangsfilter 12 aufweist, die so angebracht sind, daß die zum Netzanschluß bestimmten Eingangsklemmen (E1, E2, E3) und die zum Anschluß des Motors (3) bestimmten Ausgangsklemmen (R1, R2, R3) sind auf ein und derselben Seite (13) des Gehäuses angeordnet sind, während die zum Anschließen des Frequenzumrichters (2) dienenden Anschlüsse (K1, K2, K3 ; S1, S2, S3) auf der anderen Seite (14) des Gehäuses angeordnet sind, die dem Frequenzumrichter 2 gegenüberliegt.

2. Filtermodul nach Patentanspruch 1, dadurch gekennzeichnet, daß der Eingangsfilter (11) und der Ausgangsfilter (12) an einen gemeinsamen Erdleiter angeschlossen sind.

3. Filtermodul nach Patentanspruch 1 oder 2, dadurch gekennzeichnet, daß das Gehäuse (17) Befestigungssockel aufweist, die so gestaltet sind, daß ein Belüftungskanal (18) für den Frequenzumrichter (2) gebildet wird.

4. Filtermodul nach einem der vorhergehenden Patentansprüche, dadurch gekennzeichnet, daß er vorverdrahtet ist.

## Claims

1. Filter module for a frequency converter comprising a filter circuit housed in a casing adapted to be connected to said converter and including an input filter and an output filter so arranged that input terminals adapted to be connected to an AC line voltage and output terminals adapted to be connected to an electric motor are disposed on a common side of said casing and so that the connections to said frequency to an converter are disposed on a side of said casing which in use faces said converter.

2. Module according to claim 1 wherein said input filter and said output filter have a common ground.

3. Module according to claim 1 wherein said casing has fixing arrangements adapted to provide a passage for ventilating said frequency converter.

4. Module according to claim 1 which is pre-wired.
